# EUROPEAN PATENT APPLICATION

(11) **EP 4 664 439 A1**
(43) Date of publication of application: **17.12.2025**
(21) Application number: 24795973.7
(22) Date of filing: 19.04.2024
(51) Int. Cl.: G09F 9/00, B60R 11/02

(54) **SCREEN ASSEMBLY HAVING MOVABLE SCREEN AND VEHICLE HAVING SAME**

(30) Priority: 27.04.2023 CN 202310482686
(71) Applicant: ZHEJIANG ZEEKR INTELLIGENT TECHNOLOGY CO., LTD., Ningbo, Zhejiang 315899 (CN); Zhejiang Geely Holding Group Co., Ltd., Hangzhou, Zhejiang 310051 (CN)
(72) Inventor: ZHU, Ling, Ningbo, Zhejiang 315899 (CN); WANG, Lili, Ningbo, Zhejiang 315899 (CN); LI, Sibo, Ningbo, Zhejiang 315899 (CN)
(74) Representative: Murgitroyd & Company
(86) International application number: PCT/CN2024/088936
(87) International publication number: WO 2024/222592

(57) **Abstract**

A screen assembly having a movable screen, comprising: a screen, a screen connector (10), a front housing (20), and a rear housing (3). A screen cable (14) partially passes through a cable carrier (15) and has a first end (141) and a second end (142) exposed at different end portions of the cable carrier (15); the second end (142) of the screen cable (14) is fixed in the screen assembly, and the first end (141) is connected to the screen; one end of the cable carrier (15) is fixed on the screen connector (10), and the other end of the cable carrier (15) is fixed on the front housing (20); and an anti-friction sleeve (16) surrounds the part of the screen cable (14) located in the cable carrier (15), and the anti-friction sleeve (16) is non-integrally tightly wrapped with the cable carrier (15) or non-integrally tightly wraps the screen cable (14).

## Description

### TECHNICAL FIELD

The present application relates to the field of sliding screen technologies, and more specifically, to a screen assembly having a movable screen and a vehicle having the same.

### BACKGROUND

Currently, sliding screens are being increasingly applied in vehicles, becoming one of important interactive components of vehicles. A sliding screen may move, under control of a user, to different positions, such as a position near a driver's seat or a position near a passenger seat.

Since the sliding screen is required to be connected to a screen cable to form an electrical connection relationship with other components and parts, so as to enable the sliding screen to function properly. Therefore, as the sliding screen moves left and right, the screen cable also moves along with the sliding screen. However, the screen cable is prone to friction with other components during movement, which affects a service life of the screen cable.

### SUMMARY

In view of this, an objective of embodiments of the present application is to provide a screen assembly having a movable screen and a vehicle having the same. The screen assembly features an appropriate wiring structure, so that a screen cable of the screen assembly is less prone to wear and has a longer service life.

A screen assembly in an embodiment of the present application includes a screen, a screen-connecting member, a front casing, and a rear casing, where the front casing is connected to the rear casing; a part of the screen-connecting member is connected to the screen, and a part of the screen-connecting member is located between the front casing and the rear casing; and the screen-connecting member is capable of moving relative to the front casing and the rear casing. The screen assembly further includes a screen cable, a drag chain, and an anti-friction sleeve, where the screen cable is partially routed through the drag chain and has two ends that are respectively exposed from different ends of the drag chain, and the two ends are a first end and a second end; the second end of the screen cable is fixed inside the screen assembly, and the first end is connected to the screen; the drag chain is located between the front casing and the rear casing, one end of the drag chain is fixed on the screen-connecting member, and the other end of the drag chain is fixed on the front casing; and the anti-friction sleeve encloses a part, located in the drag chain, of the screen cable, the anti-friction sleeve is connected with one of the drag chain and the screen cable, and the anti-friction sleeve is not entirely connected with the one of the drag chain and the screen cable in a tightly wrapped manner.

Optionally, a part of the anti-friction sleeve is connected with the one of the drag chain and the screen cable; the anti-friction sleeve is provided with a connected region and a loose region; the connected region of the anti-friction sleeve is in contact with and connected to the screen cable; and the loose region of the anti-friction sleeve is at least partially located in the drag chain.

Optionally, at least in a partial region of the drag chain, the screen cable is suspended in the drag chain; and the loose region of the anti-friction sleeve is spaced apart from the screen cable, and is also spaced apart from the drag chain.

Optionally, the anti-friction sleeve is provided in either of the following two manners: the anti-friction sleeve is a tubular woven net, the woven net has two connected regions that are respectively exposed from two ends of the drag chain, and the two connected regions abut on and are connected, in a bundling manner, to a part of the screen cable that is located outside the drag chain; or the anti-friction sleeve is a tubular woven net, the woven net has two connected regions that are respectively exposed from two ends of the drag chain, and the two connected regions are fixedly connected to the drag chain.

Optionally, the screen assembly having a movable screen further includes a controller, a driving portion, a control cable, and a host-connecting cable, where a second component plate located on lower sides of the screen-connecting member and the drag chain is disposed in the screen assembly; the driving portion is fixed to a lower side on one end of the second component plate; the controller is disposed on a side of the driving portion; the screen cable is connected to the screen at the first end, and is connected, at the second end, to a first terminal having a fixed position; and the first terminal is used to form an electrical connection relationship with an entertainment host, such that the screen is electrically connected to the entertainment host. The driving portion includes a motor capable of driving the screen-connecting member to move, and an interface member electrically connected to a motor control unit; one end of the control cable is connected to the controller, and the other end of the control cable is connected to the interface member, such that the controller is electrically connected to the driving portion; one end of the host-connecting cable is connected to the controller, and the other end of the host-connecting cable is connected to a second terminal having a fixed position; the second terminal is used to form an electrical connection relationship with the entertainment host, such that the controller is electrically connected to the entertainment host; and at least a part of the controller, the first terminal, the second terminal, the control cable, and the host-connecting cable are arranged on a lower side of the second component plate.

Optionally, the front casing includes a first component plate vertically arranged and the second component plate horizontally arranged; the screen assembly further includes a decorative roller shutter and a functional casing; the decorative roller shutter includes a first roller shutter and a second roller shutter that are respectively connected to a left part and a right part of the screen-connecting member; and each of the first roller shutter and the second roller shutter mates with the front casing and the rear casing, and is capable of sliding from upper sides of the first component plate and the second component plate to lower sides of the first component plate and the second component plate relative to the front casing and the rear casing. The screen assembly includes the functional casing located on the lower side of the second component plate, and the functional casing is located on a movement trajectory of the second roller shutter, and is located on a side, close to the controller, of the driving portion, and near the controller; and the functional casing is capable of accommodating the second roller shutter and causing the control cable extending from the controller toward the interface member to be mated with the functional casing, to constrain a routing direction of the control cable.

Optionally, the functional casing is fixedly connected to the second component plate, and includes a widened portion, a narrowed portion, and a snap-in position provision portion that are connected to each other as one piece, where a diameter of the widened portion is greater than a diameter of the narrowed portion; the widened portion is used to accommodate the second roller shutter; the snap-in position provision portion is formed by protruding from a side surface of the widened portion toward a direction away from the widened portion, and is used to provide a fixing point for each of the second terminal and the first terminal, so as to constrain the host-connecting cable and the screen cable; and the narrowed portion is formed by extending from an end, close to the driving portion, of the widened portion toward the driving portion, and is provided with a hook, where the hook is used to allow the control cable, which extends from the controller to the driving portion, to pass through the hook, so as to constrain a routing direction of the control cable.

Optionally, a routing direction of the screen cable from the first terminal to the screen is configured as follows: starting from the first terminal, the screen cable extends upward from the lower side of the second component plate, extends past a front side of the first component plate into a space between the rear casing and the front casing to enter the drag chain, extends from the front casing toward the rear casing, and further extends upward along the screen-connecting member from a side of the rear casing facing the front casing into a space between the screen-connecting member and the screen.

Optionally, the screen assembly having a movable screen further includes two routing direction constraining members, where one of the two routing direction constraining members is disposed on a front surface of the first component plate, and the other of the two routing direction constraining members is disposed on the screen-connecting member; the routing direction constraining members are used to constrain the routing direction of the screen cable; each of the routing direction constraining members includes a guiding body and a connection portion that are connected to each other as one piece; the connection portion is used to be directly inserted into the screen-connecting member to fix a corresponding routing direction constraining member onto the screen-connecting member; and the guiding body is provided with an arc-shaped groove, and the arc-shaped groove is used to be mated with a part of the screen cable, so as to constrain a routing direction of the part of the screen cable.

Optionally, the connection portion is formed by extending from the guiding body toward a direction away from the guiding body and includes a plurality of barbed bodies; the plurality of barbed bodies are arranged in sequence at intervals from a connection point between the connection portion and the guiding body toward the direction away from the guiding body, such that the connection portion is in a shape of a Christmas tree, with a crown of the Christmas tree far away from the guiding body; and the connection portion is further provided with an abutment block.

Each of the first component plate and the screen-connecting member is provided with a mating hole that is used for snap-in connection with a corresponding routing direction constraining member; the abutment block is used to abut against an inner wall of the mating hole; and the connection portion is used to be snapped into the mating hole to fix a corresponding routing direction constraining member onto the first component plate or the screen-connecting member.

Optionally, a coarsely-locating portion is provided on the screen-connecting member; the coarsely-locating portion is located near an end, close to the screen, of the drag chain, for allowing a part of the screen cable to be coarsely located; a mating hole for insertion of the routing direction constraining member is formed at a groove bottom of the coarsely-locating portion; the coarsely-locating portion is configured to accommodate the routing direction constraining member; and a unilateral distance between the coarsely-locating portion and the guiding body is at least 20% of a width of the guiding body.

Optionally, the functional casing allows a downward-protruding tangible part to be present on a lower surface of the second component plate; a frame region for mounting the driving portion is formed between the front casing and the rear casing, and the frame region allows a downward-protruding tangible part to be present on the lower surface of the second component plate; a part of the second component plate is exposed from a space between the functional casing, the driving portion, and the frame region; and the exposed part of the second component plate, and the surrounding functional casing, the driving portion, and the frame region together define a height drop region, where the controller is disposed in the height drop region.

An embodiment of the present application further provides a vehicle, including the screen assembly having a movable screen described above, where the screen assembly is fixed onto a dashboard assembly, and a recessed region used to accommodate a part of the screen assembly is disposed inside the dashboard assembly.

In conclusion, by means of allowing a screen assembly to include a drag chain disposed between a front casing and a rear casing, allowing a screen cable to be partially routed through the drag chain, and disposing an anti-friction sleeve between the drag chain and the screen cable, it may be ensured in the present application that the screen cable may be not subject to wear and tear that affects its service life during vibration and bumpy road conditions and movement along with a screen-connecting member, greatly reducing a breaking risk of the screen cable due to a durability failure.

The above description is only an overview of the technical solutions of the present application. In order to more clearly understand the technical means of the present application, the present application can be implemented according to the contents of the description; and in order to make the above and other objectives, features, and advantages of the present application more obvious and comprehensible, preferred embodiments are particularly given below, and are described in detail as follows with reference to the accompanying drawings.

### BRIEF DESCRIPTION OF THE DRAWINGS

FIG. 1 is a schematic diagram of positions of a screen-connecting member, a front casing, a rear casing, and a screen relative to each other in related art.
FIG. 2 is a schematic comparison diagram of parts of a rear casing and parts of a front casing before and after a screen assembly is assembled, according to an embodiment of the present application.
FIG. 3 is schematic diagram 1 of a screen assembly according to an embodiment of the present application.
FIG. 4 is a schematic diagram 1 of a partial structure of a screen assembly according to an embodiment of the present application.
FIG. 5 is a schematic diagram of a relative position relationship between a guide rod, a front casing, a first functional member, and a second functional member according to an embodiment of the present application.
FIG. 6 is a schematic comparison diagram before and after a frame region and a driving portion are fitted together, according to an embodiment of the present application.
FIG. 7 is a schematic diagram 2 of a partial structure of a screen assembly according to an embodiment of the present application.
FIG. 8 is a schematic diagram of a roll ball and a mating groove being fitted with each other, according to an embodiment of the present application.
FIG. 9 is a schematic diagram of a roll ball, a contact piece, and a mating groove being fitted with each other, according to an embodiment of the present application.
FIG. 10 is schematic diagram 2 of a screen assembly according to an embodiment of the present application.
FIG. 11 is a schematic diagram 3 of a partial structure of a screen assembly according to an embodiment of the present application (a drag chain is hatched for illustration).
FIG. 12 is a schematic diagram of a local flat structure of an anti-friction sleeve according to an embodiment of the present application.
FIG. 13 is a schematic diagram of a screen cable with an anti-friction sleeve before and after being placed in a drag chain, according to an embodiment of the present application.
FIG. 14 is a schematic diagram of a screen cable being suspended in at least a partial region of a drag chain according to an embodiment of the present application.
FIG. 15 is a schematic diagram 4 of a partial structure of a screen assembly according to an embodiment of the present application.
FIG. 16 is a schematic diagram of a routing direction constraining member being assembled with a coarsely-locating portion, according to an embodiment of the present application.
FIG. 17 is a schematic diagram of a routing direction constraining member according to an embodiment of the present application.
FIG. 18 is a schematic diagram of a routing direction constraining member and a special-shaped hole being mated with each other, according to an embodiment of the present application.
FIG. 19 is a schematic comparison diagram of a driving portion, a controller, a functional casing, and a second roller shutter before and after being assembled with a front casing and a rear casing, according to an embodiment of the present application.
FIG. 20 is a schematic diagram 5 of a partial structure of a screen assembly according to an embodiment of the present application.
FIG. 21 is a schematic diagram 6 of a partial structure of a screen assembly according to an embodiment of the present application.
FIG. 22 is schematic diagram 3 of a screen assembly according to an embodiment of the present application.
FIG. 23 is schematic diagram 1 of a functional casing according to an embodiment of the present application.
FIG. 24 is schematic diagram 2 of a functional casing according to an embodiment of the present application.
FIG. 25 is a schematic diagram of a first terminal and a second terminal being assembled with a snap-in position provision portion, according to an embodiment of the present application.
FIG. 26 is a schematic diagram of a front casing and a rear casing being assembled with each other, according to an embodiment of the present application.
FIG. 27 is a schematic comparison diagram of a controller being mounted at different positions of a second component plate, according to an embodiment of the present application.

### List of reference signs:

A. screen; ①, ②, ③, and ④. connection point; B. frame region; C. lower edge; D. height drop region; a. length; b. distance; c. distance; d. width;
10. screen-connecting member; 101. coarsely-locating portion; 20. front casing; 201. first front sub-member; 202. second front sub-member; 2021. first component plate; 2022. second component plate; 203. third front sub-member; 2031. mating projection; 204. mating groove; 205. supporting groove; 3. rear casing; 31. first rear sub-member; 311. lug; 32. second rear sub-member; 321. mating receptacle; 4. driving portion; 41. motor; 42. interface member; 5. first pulling cord; 6. second pulling cord; 7. first functional member; 8. second functional member; 9. guide rod; 11. compensating element; 12. roll ball; 13. contact piece; 14. screen cable; 141. first end; 142. second end; 15. drag chain; 16. anti-friction sleeve; 161. connected region; 162. loose region; 17. routing direction constraining member; 171. guiding body; 172. connection portion; 1721. barbed body; 1722. through groove; 173. abutment block; 18. special-shaped hole; 19. controller; 200. control cable; 21. host-connecting cable; 22. first terminal; 23. second terminal; 24. functional casing; 241. widened portion; 242. narrowed portion; 2421. hook; 243. snap-in position provision portion; 2431. snap-in hole; 25. first roller shutter; and 26. second roller shutter.

### DETAILED DESCRIPTION OF THE EMBODIMENTS

The specific implementations of the present application are described in more detail below with reference to the accompanying drawings and embodiments. The following embodiments are intended to illustrate the present application, but are not intended to limit the scope of the present application.

In the specification and claims of the present application, the terms such as "first" and "second" are intended to distinguish between similar objects but do not necessarily indicate a specific order or sequence.

In the description of the present application, unless otherwise clearly specified and defined, meanings of terms "provided", "mounted", "connected to", and "connected with" should be understood in a broad sense. For example, the connection may be a fixed connection, a removable connection, or an integral connection; may be a mechanical connection or an electrical connection; or may be a direct connection or an indirect connection by using an intermediate medium. In some cases, when expressing a fixed connection between an object and another object, a specific connection method may also include an integral connection. A person of ordinary skill in the art may understand specific meanings of the foregoing terms based on a specific situation.

In the present application, orientation or position relationships indicated by terms such as "upper", "lower", "left", "right", "front", "rear", "top", "bottom", "inner", and "outside" are orientation or position relationships shown in the accompanying drawings or when the product of the present application is usually placed in operation. These terms are only used to facilitate description and simplify the description, rather than to indicate or imply that the mentioned apparatus or components must have a specific orientation or must be established and operated in a specific orientation. Therefore, these terms should not be construed as a limitation to the present application.

In the present application, the terms "include", "comprise", or any other variations thereof are intended to cover a non-exclusive inclusion, and in addition to those elements listed, other elements not explicitly specified may also be included.

In the description of this specification, the description with reference to the terms such as "one embodiment", "some embodiments", "exemplarily", "a specific example", "optionally", "further", "more detailed description", "preferably", "further provided", "further comprise", or "some examples" means that the specific features, structures, materials, or characteristics described with reference to the embodiment or example are included in at least one embodiment or example of the present application. In this specification, the schematic representation of the above terms is not necessarily directed to the same embodiment or example. Furthermore, the specific features, structures, materials, or characteristics described may be combined in a suitable manner in any one or more embodiments or examples. In addition, various embodiments or examples described in the specification, as well as features of various embodiments or examples, may be integrated and combined by those skilled in the art without any contradiction.

It should be noted that, in the description of the present application, it should be understood that orientations or position relationships indicated by terms such as "end" are orientations or position relationships as shown in the drawings, and these terms are used to facilitate description of the present application and simplify the description, but not to indicate or imply that the mentioned components must have a specific orientation and must be constructed and operated in a specific orientation, and thus, these terms cannot be understood as a limitation to the present application.

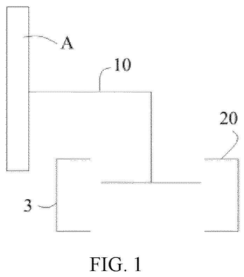

FIG. 1 is a schematic diagram of positions of a screen-connecting member, a front casing, a rear casing, and a screen relative to each other in related art. As shown in FIG. 1, a screen assembly disposed inside a vehicle generally includes a screen A, a screen-connecting member 10, a front casing 20, a rear casing 3, and a driving portion (not shown in FIG. 1). A lower part of the screen-connecting member 10 is located between the front casing 20 and the rear casing 3, and an upper part of the screen-connecting member 10 extends beyond the front casing 20 and the rear casing 3 and is connected to the screen A. The screen A is exposed to an occupant compartment. A driving portion can drive the screen-connecting member 10 to move. Various mechanisms are disposed between the front casing 20 and the rear casing 3, and these mechanisms are used to be coordinated with the screen-connecting member 10, so as to constrain the screen-connecting member 10 to move in a left and right direction of the vehicle. In this way, the screen-connecting member 10 is driven to move left and right, that is, the screen A can be brought along to move left and right.

In view of the foregoing description, since the screen A is required to be connected to a screen cable (not shown in FIG. 1), so as to form an electrical connection relationship with other components and parts and further to enable the screen A to operate normally, the screen cable also moves left and right along with the screen A in the foregoing process in which the screen assembly moves left and right. The inventors of the present application find that the screen cable may friction with another component of the screen assembly during movement along with the screen A, which affects a service life of the screen cable.

In view of the foregoing technical problem, an embodiment of the present application provides a screen assembly having an appropriate wiring structure.

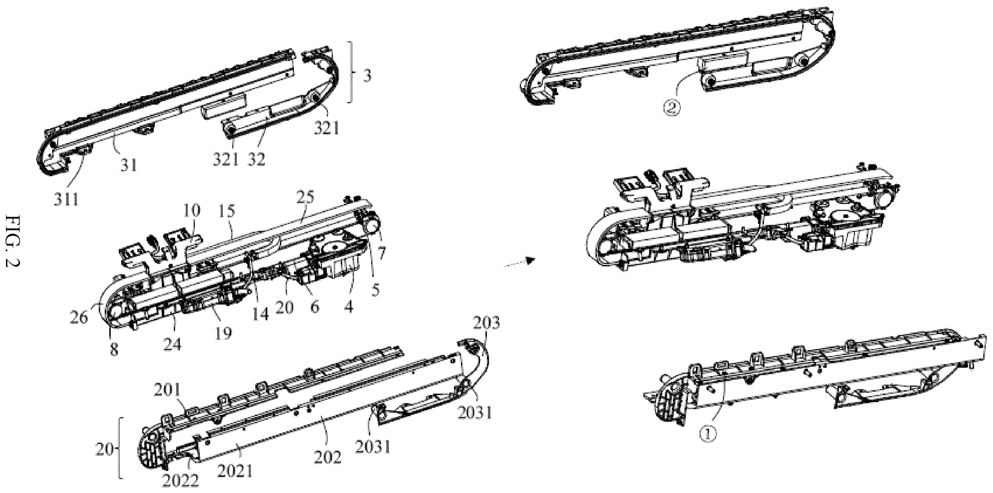

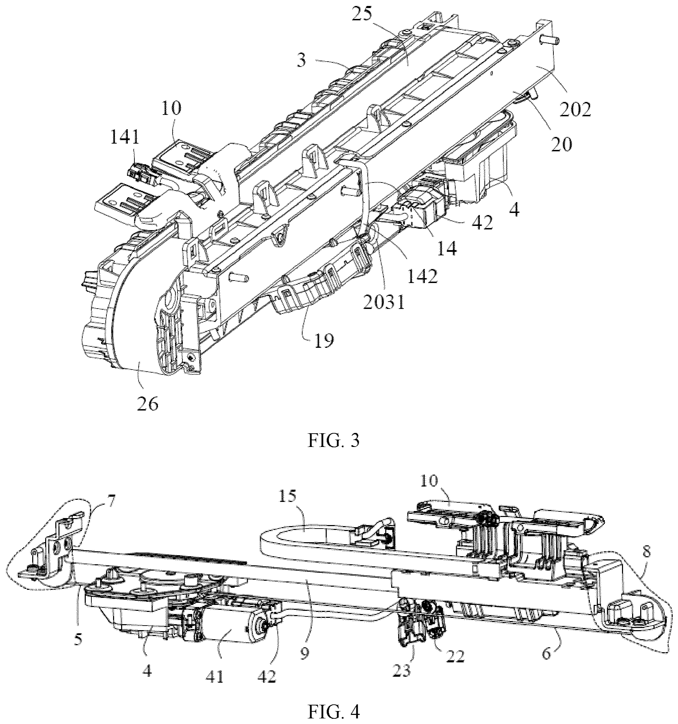

As shown in FIG. 2 and FIG. 3, an embodiment provides a vehicle. A screen assembly is disposed at a front part of the vehicle. The screen assembly is fixed on a dashboard assembly (not shown in FIG. 2 or FIG. 3). A recessed region used for accommodating a part of the screen assembly is provided in the dashboard assembly. The screen assembly includes a screen (not shown in FIG. 2 or FIG. 3), a screen-connecting member 10, a front casing 20, a rear casing 3, and a driving portion 4. The front casing 20 is connected to the rear casing 3. An upper part of the screen-connecting member 10 is connected to the screen, and a lower part of the screen-connecting member 10 extends into a space between the front casing 20 and the rear casing 3. The driving portion 4 is located at a lower left part of the screen assembly, and the screen-connecting member 10 can move left and right relative to the front casing 20 and the rear casing 3. Among the components mentioned above, a part of the screen-connecting member 10, together with the screen, is exposed to the occupant compartment. Most parts of a structure of the screen-connecting member 10, the front casing 20, the rear casing 3, and the driving portion 4 are not exposed to be directly visible to an occupant. Most parts of the structure of the screen-connecting member 10, the front casing 20, the rear casing 3, and the driving portion 4 are at least partially located inside the dashboard assembly. The front casing 20 and the rear casing 3 are fixedly connected to the dashboard assembly.

For example, the front casing 20 includes a first front sub-member 201, a second front sub-member 202, and a third front sub-member 203. The first front sub-member 201 is approximately an L-shaped member with an opening facing left. The second front sub-member 202 is approximately an L-shaped member with an opening facing rearward, and includes a first component plate 2021 that is substantially vertically arranged and a second component plate 2022 that is substantially horizontally arranged. The first component plate 2021 is located on front sides of the screen-connecting member 10 and the screen, and the second component plate 2022 is located on a lower side of the screen-connecting member 10. The third front sub-member 203 is approximately a right-angled hook-shaped (" L "-shaped) member with an opening facing right. After the first front sub-member 201, the second front sub-member 202, and the third front sub-member 203 are assembled, a part of the first front sub-member 201 is fixed at an upper part of the first component plate 2021 (with one of connection positions being a connection point ①, for example), and another part of the first front sub-member 201 is located on a right side of the second front sub-member 202. An upper end of the third front sub-member 203 is connected to a left part of the first front sub-member 201, bypasses a left part of the second front sub-member 202 from the upper end, and finally extends to a lower side of the first component plate 2021.

Correspondingly, the rear casing 3 includes a first rear sub-member 31 and a second rear sub-member 32. The first rear sub-member 31 is approximately an L-shaped member with an opening facing left, and the second rear sub-member 32 is approximately a right-angled hook-shaped (" 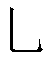 "-shaped) member with an opening facing right. After the first rear sub-member 31 and the second rear sub-member 32 are assembled, an upper end of the second rear sub-member 32 is connected to a left part of the first rear sub-member 31, bypasses a left part of the first rear sub-member 31 from the upper end, and finally extends to a lower side of the second rear sub-member 32. For one of positions, at which the first rear sub-member 31 and the second rear sub-member 32 are connected, reference is made to a connection point ②, for example.

For example, the third front sub-member 203 is provided with mating projections 2031 protruding rearward relative to a peripheral side of the third front sub-member 203. The second rear sub-member 32 is provided with mating receptacles 321 that are respectively in male-female fittings with the mating projections 2031. In addition, lugs 311 are provided on a lower edge of the first rear sub-member 31. In this embodiment, after the front casing 20 is assembled with the rear casing 3, the mating projections 2031 are respectively mated with the mating receptacles 321, the lugs 311 extend beneath the second component plate 2022, and bolts respectively pass through the lugs 311 and the second component plate 2022, to fasten the rear casing 3 and the front casing 20 together. Once the front casing 20 is assembled with the rear casing 3, a space is formed between the front casing 20 and the rear casing 3, and a lower part of the screen-connecting member 10 extends into the space.

It should be noted that, in this embodiment, there is another connection point between the front casing 20 and the rear casing 3. An objective of the another connection point is to cause the front casing 20 and the rear casing 3 to be firmly connected with each other. This is not exhaustive herein. For those skilled in the art, once a connection relationship between two structures is known, a quantity of connection points and forms of connection between the two structures can be flexibly modified and designed as required. Similarly, even if a specific design of connections between one structure and another structure is not described in detail throughout the present application, those skilled in the art are still able to implement such connections.

With continued reference to FIG. 2, in the space enclosed by the front casing 20 and the rear casing 3, the screen assembly further includes a decorative roller shutter, a first pulling cord 5, a second pulling cord 6, a first functional member 7, and a second functional member 8. The decorative roller shutter is used to cover structures of the screen assembly that are located between the front casing 20 and the rear casing 3, and is exposed to the occupant compartment and visible to an occupant. The decorative roller shutter includes a first roller shutter 25 and a second roller shutter 26. The first roller shutter 25 is located on a left side of the screen-connecting member 10 and is fixedly connected to a left part of the screen-connecting member 10. The second roller shutter 26 is located on a right side of the screen-connecting member 10 and is fixedly connected to a right part of the screen-connecting member 10. The first functional member 7 and the second functional member 8 are located on a left side and a right side of the screen assembly, respectively. The first functional member 7 is fixedly connected to a left part of the rear casing 3 and a left part of the first component plate 2021, so that the first functional member 7 is fixedly positioned within the screen assembly. The second functional member 8 is fixedly connected to a right part of the rear casing 3 and a right part of the second component plate 2022, so that the second functional member 8 is fixedly positioned within the screen assembly.

In continuation of the foregoing, each of the first functional member 7 and the second functional member 8 is provided with a guide pulley. Correspondingly, the driving portion 4 includes a winding reel capable of retracting and releasing the first pulling cord 5 and the second pulling cord 6. One end of the first pulling cord 5 is located within the winding reel, extends from the winding reel toward the screen-connecting member 10 while being guided by the guide pulley on the first functional member 7, and is finally fixedly connected to the left part of the screen-connecting member 10. Similarly, one end of the second pulling cord 6 is located within the winding reel, extends from the winding reel toward the screen-connecting member 10 while being guided by the guide pulley on the second functional member 8, and is finally fixedly connected to the right part of the screen-connecting member 10. In this embodiment, the winding reel is configured to rotate in one direction to retract the second pulling cord 6 and release the first pulling cord 5, and to rotate in an opposite direction to release the second pulling cord 6 and retract the first pulling cord 5. Based on this, a force can be applied on the screen-connecting member 10 in either a leftward direction or a rightward direction by controlling a rotation direction of the winding reel.

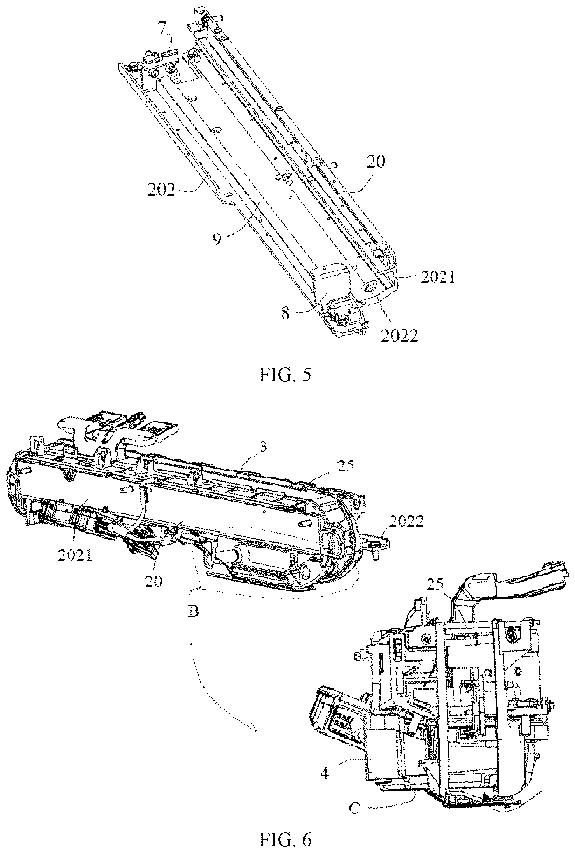

With further reference to FIG. 4 and FIG. 5, to apply forces on the screen-connecting member 10 in different directions, the driving portion 4 in this embodiment further includes a motor 41 that can drive the winding reel to rotate in two directions opposite to each other. The screen assembly further includes a guide rod 9 disposed in the left-right direction. The guide rod 9 is disposed between the first functional member 7 and the second functional member 8, and two ends of the guide rod 9 are fixedly connected to the first functional member 7 and the second functional member 8, respectively. The guide rod 9 is mounted across the second component plate 2022 of the second front sub-member 202, and is connected to the screen-connecting member 10 by using a linear bearing (not shown in FIG. 4 or FIG. 5). In this way, when the screen-connecting member 10 is pulled by the first pulling cord 5 or the second pulling cord 6, the screen-connecting member 10 can move left or right relative to the front casing 20 and the rear casing 3, so as to drive the screen connected to the screen-connecting member 10 to move left or right.

With further reference to FIG. 6, to ensure that the driving portion 4 is firmly disposed in the screen assembly, for example, the third front sub-member 203 and the second rear sub-member 32 in this embodiment are configured as follows: after the front casing 20 is assembled with the rear casing 3, the third front sub-member 203 and the second rear sub-member 32 are assembled to form a frame region B in which the driving portion 4 may be mounted; after the driving portion 4 is fixedly mounted in the frame region B, the driving portion 4 is located on a lower side at a left end of the second component plate 2022 with support from the third front sub-member 203 and the second rear sub-member 32, and is fixedly connected to the third front sub-member 203 and the second rear sub-member 32; in addition, there is a certain space (as shown by a solid arrow in FIG. 6) between a lower edge C of the driving portion 4 and lowermost parts of the third front sub-member 203 and the second rear sub-member 32, and this space can accommodate the first roller shutter 25 when the first roller shutter 25 moves to a lower part of the screen assembly due to movement of the screen-connecting member 10.

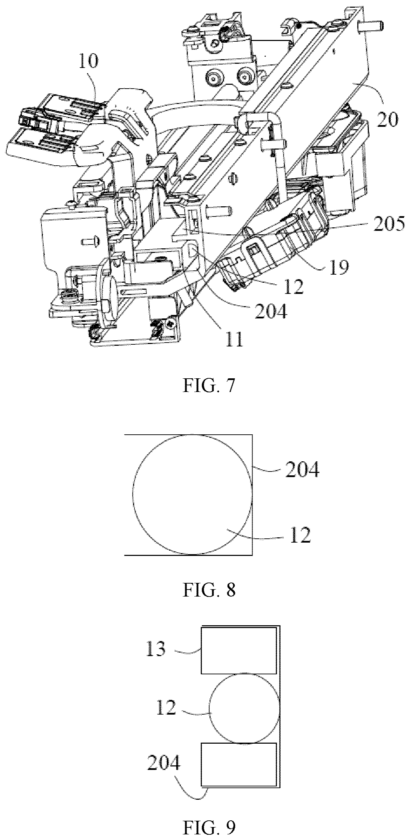

With further reference to FIG. 7 and FIG. 8, the screen assembly in this embodiment further includes a compensating element 11. The compensating element 11 is fixed to a front part of the screen-connecting member 10. A roll ball 12 is provided on a surface (that is, a front surface) of the compensating element 11 that faces the front casing 20. Correspondingly, the front casing 20 is provided with a mating groove 204 formed in the left-right direction. The roll ball 12 extends into the mating groove 204 and is in contact with an upper inner wall, a lower inner wall, and a front inner wall of the mating groove 204. As the screen-connecting member 10 moves left and right, the roll ball 12 can roll within the mating groove 204 synchronously. The roll ball 12 not only imposes no hindrance on the movement of the screen-connecting member 10, but also ensures movement stability of the screen-connecting member 10 to a certain extent.

A more detailed description of a beneficial effect of providing the roll ball 12 is as follows: when the vehicle experiences vibrations or jolts, a limiting relationship is formed between the roll ball 12 and the mating groove 204. In this way, the movement stability of the screen-connecting member 10 can be further ensured. Certainly, a quantity of roll balls 12 is not limited to one. Alternatively, a design scheme that a plurality of roll balls 12 are arranged in an array on the front surface of the compensating element 11 may be adopted. In this case, at least one of the plurality of roll balls 12 is in contact with an upper surface of the mating groove 204, and at least one of the plurality of roll balls 12 is in contact with a lower surface of the mating groove 204.

With further reference to FIG. 9, optionally, the roll ball 12 may extend into the mating groove 204 without being in contact with an upper wall and a lower wall of the mating groove 204. Instead, a soft contact piece 13 (for example, made of rubber) may be provided at each of an upper part and a lower part of the mating groove 204, such that the two soft contact pieces 13 are in contact with the roll ball 12 under a certain force that does not impede rolling of the roll ball 12. In this way, the arrangement of the compensating element 11 and the roll ball 12 can also achieve the effect of enhancing the movement stability of the screen-connecting member 10. Furthermore, the soft contact pieces 13 can also ensure that the roll ball 1 moves quietly.

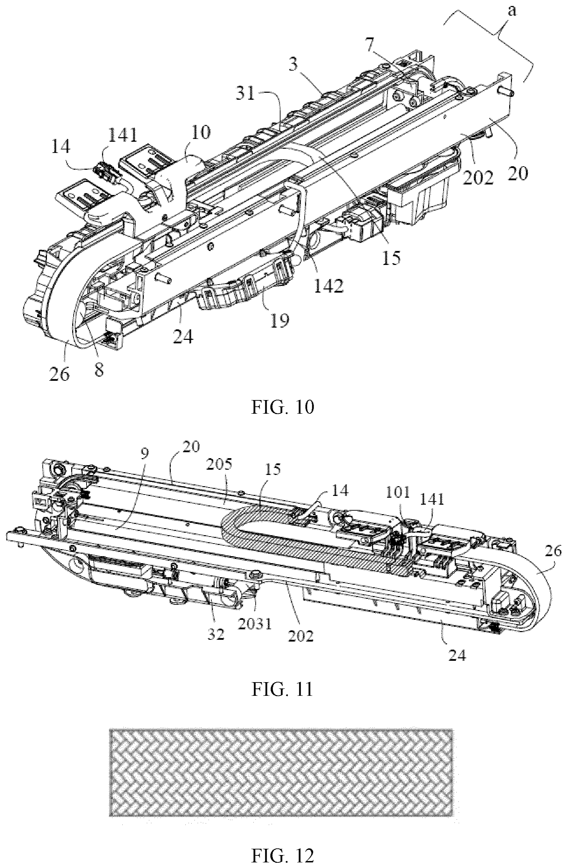

With further reference to FIG. 10 and FIG. 11, in this embodiment, a screen cable 14 is connected to the screen. To prevent the screen cable 14 from being excessively worn due to it repeatedly making contact with any part of the screen assembly during movement driven by the screen-connecting member 10, for example, the screen assembly further includes a drag chain 15 and an anti-friction sleeve 16. The screen cable 14 is partially routed through the drag chain 15 and has two ends that are exposed from different ends of the drag chain 15, respectively, and the two ends are a first end 141 and a second end 142. The second end 142 of the screen cable 14 is fixed inside the screen assembly, and the first end 141 is fixedly connected to the screen. In addition, the drag chain 15 is located between the front casing 20 and the rear casing 3, one end of the drag chain 15 is fixed on a rear surface of the screen-connecting member 10, and the drag chain 15 extends forward from the end in a bent posture while bypassing the screen-connecting member 10 from a left side of the screen-connecting member 10, and is finally fixed to the front casing 20 at the front side of the screen-connecting member 10. In other words, one end of the drag chain 15 is fixed to the screen-connecting member 10, and the other end of the drag chain 15 is fixed to the front casing 20.

In continuation of the forgoing, the anti-friction sleeve 16 at least encloses a part, located in the drag chain 15, of the screen cable 14, the anti-friction sleeve 16 is connected with one of the drag chain 15 and the screen cable 14, and the anti-friction sleeve 16 is not entirely connected with the one of the drag chain 15 and the screen cable 14 in a tightly wrapped manner. "Not entirely connected in a tightly wrapped manner" herein refers to that when the anti-friction sleeve 16 is connected to the drag chain 15, the anti-friction sleeve 16 is not attached to the drag chain 15 entirely like an inner membrane. For example, the anti-friction sleeve 16 is not adhered to the drag chain 15 entirely and tightly, but is partially connected to the drag chain 15. When the anti-friction sleeve 16 is connected to the screen cable 14, the anti-friction sleeve 16 does not wraps a peripheral side of the screen cable 14 entirely and tightly in the manner of how a conductor is connected to an insulation layer in a cable, but the anti-friction sleeve 16 is instead only partially connected to the drag chain 15.

For example, to ensure stability of the connection of the drag chain 15 to both the screen-connecting member 10 and the front casing 20, a rear end of the drag chain 15 is fixed to the screen-connecting member 10 and supported by the screen-connecting member 10. A supporting groove 205 used for accommodating the drag chain 15 is provided on the front casing 20, and the rear end of the drag chain 15 is fixed in the supporting groove 205. When the screen-connecting member 10 moves with the drag chain 15, the supporting groove 205 can accommodate a part of the drag chain 15 that gets close to the front casing 20 due to movement of the drag chain 15. In addition, the screen-connecting member 10 also has a sufficient size to support a part of the drag chain 15 that gets close to the rear casing 3 due to movement of the drag chain 15.

In conclusion, in this embodiment, since the anti-friction sleeve 16 is disposed, the screen cable 14 is unlikely to be worn by the drag chain 15, which does not affect a service life of the screen cable 14. For ease of understanding, the following related technologies are required to be discussed first for this beneficial effect:
Although a drag chain component is generally used to allow a cable to pass through the drag chain, so as to reduce wear of the cable caused by friction with an external environment, the situation is more complicated in the case of the screen assembly in this embodiment that is mounted inside a vehicle.

The inventors of the present application have found that, since most of the structure of the screen assembly is required to be disposed inside the dashboard assembly, in consideration of weight reduction, cost and arrangement space saving, a length of the structure, which is located inside the dashboard assembly, of the screen assembly in a front-rear direction (that is, a width of the screen assembly, as shown in FIG. 10) is limited to a value ranging from 70 mm to 150 mm, for example. In this way, in the case that the drag chain 15 is required to be disposed between the front casing 20 and the rear casing 3 to protect a part of the screen cable 14, a maximum distance between the front casing 20 and the rear casing 3 after the front casing 20 is assembled with the rear casing 3 can only be set to a relatively small value, for example, a value approximately ranging from 40 mm to 120 mm. Under these size limitations, the drag chain 15 disposed between the front casing 20 and the rear casing 3 should have a very small diameter. For example, an inner diameter of the drag chain 15 preferably ranges from approximately 6 mm to 10 mm, and a length of the drag chain 15 preferably ranges from 400 mm to 450 mm.

In view of the limitation on the inner diameter of the drag chain 15, since the screen cable 14 routed through the drag chain 15 should also have a certain diameter to meet a requirement for electrical signal transmission, in consideration of cost and arrangement space saving requirements, the diameter of the screen cable 14 should be even smaller, for example, ranges from approximately 3.5 mm to 6 mm. That is, if each of the screen cable 14 and the drag chain 15 is designed with a preferred size, a unilateral clearance between the screen cable 14 and an inner sidewall of the drag chain 15 may be extremely small, for example, only about 2 mm. Such a small clearance may result in a high probability of friction occurring between the screen cable 14 and the drag chain 15. Further, since the screen-connecting member 10 may drive the drag chain 15 to move, different segments of the entire drag chain 15 may form U-shaped bends alternately (as the screen-connecting member 10 moves left and right, and different segments of the drag chain 15 are bent either forward or backward, forming U-shaped bends). Consequently, a probability of friction occurring between the drag chain 15 and the screen cable 14 may be further increased.

Still further, since the diameter of the screen cable 14 having a preferred size is relatively small, for example, may only range from approximately 3.5 mm to 6 mm, thicknesses of various outer coatings (such as an insulation layer) of the screen cable 14 may be smaller accordingly. The combination of the high friction probability and the small thickness of the outer coating (of the screen cable 14) will undoubtedly lead to a higher risk of wear and a reduced service life of the screen cable 14 (having a preferred size) during actual use of the screen assembly, ultimately affecting the quality of the screen assembly and increasing the repair frequency of the screen assembly.

In continuation of the foregoing, in view of the foregoing particular conditions of the screen assembly in the vehicle, in this embodiment, the anti-friction sleeve 16 is disposed between the drag chain 15 and the screen cable 14. The anti-friction sleeve 16 can prevent direct friction between the drag chain 15 and an outer surface of the screen cable 14. The anti-friction sleeve 16 can serve as a buffer between the drag chain 15 and the screen cable 14, thereby ensuring the service life of the screen cable 14.

With further reference to FIG. 12, for example, the anti-friction sleeve 16 is a soft member and made of polyester monofilament, and is specifically in a form of a tubular woven net.

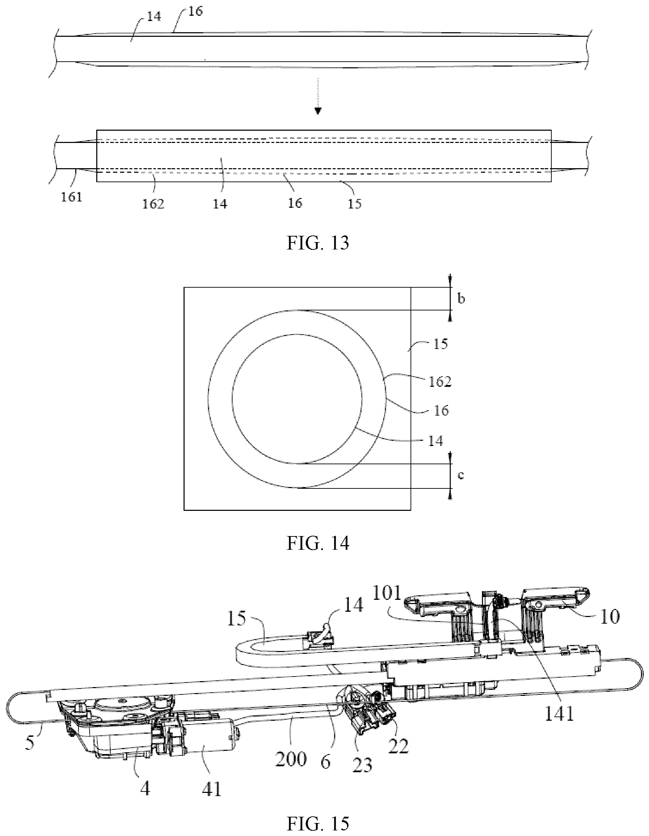

With further reference to FIG. 13, when the anti-friction sleeve 16 is connected to the drag chain 15, for example, the anti-friction sleeve 16 is provided with a connected region 161 and a loose region 162, the anti-friction sleeve 16 is in contact with and connected to the screen cable 14 at the connected region 161 of the anti-friction sleeve 16, and the loose region 162 of the anti-friction sleeve 16 is at least partially located in the drag chain 15. This arrangement is described in more detail as follows:
Since there may only be a relatively small (for example, about 2 mm) unilateral distance between the screen cable 14 having a preferred size and the inner sidewall of the drag chain 15, there is a possibility that a part of the anti-friction sleeve 16 may be pinched between chain links of the drag chain 15 during movement of the drag chain 15. In view this, in this embodiment, the anti-friction sleeve 16 is in close contact and connected to the screen cable 14 at the connected region 161 of the anti-friction sleeve 16, while the anti-friction sleeve 16 is in a loose state relative to the screen cable 14 at the loose region 162 of the anti-friction sleeve 16. In this way, even if a plurality of parts of the anti-friction sleeve 16 are pinched between chain links, since "the plurality of parts" of the anti-friction sleeve 16 are in a loose state, such pinching between chain links does not have a significant negative impact on the service life of the anti-friction sleeve 16. Preferably, the negative impact can be further reduced if the anti-friction sleeve 16 is made of a material capable of withstanding a certain degree of tensile force.

In contrast, if the anti-friction sleeve 16 is entirely and tightly wrapped around (such as being entirely adhered to) the peripheral side of the screen cable 14, then when a plurality of parts of the anti-friction sleeve 16 are pinched between chain links and such pinching repeatedly occurs over time, the anti-friction sleeve 16 would be subjected to repeated external forces pulling the anti-friction sleeve 16 outward from the screen cable 14. As a result, a plurality of local parts of the anti-friction sleeve 16 may be torn off from the screen cable 14 or damaged, which ultimately affects the service life of both the anti-friction sleeve 16 and the screen cable 14. Similarly, when the anti-friction sleeve 16 is connected to the drag chain 15, the anti-friction sleeve 16 should not be connected to the drag chain 15 in an entirely-adhering manner, which may cause a plurality of parts of the anti-friction sleeve 16 to be stretched during movement of chain links relative to one another.

Based on the foregoing considerations, when the anti-friction sleeve 16 is connected to the drag chain 15, specifically, the anti-friction sleeve 16 in this embodiment has, as shown in FIG. 13, parts that are exposed from two ends of the drag chain 15, respectively, and the connected region 161 is located on each of the parts of the anti-friction sleeve 16 that are exposed from the drag chain 15, that is, two connected regions 161 are disposed on the anti-friction sleeve 16. In this embodiment, the two connected regions 161 are respectively connected to the parts of the screen cable 14 outside the drag chain 15 in the manner of adhesive tape bundling. Certainly, optionally, the anti-friction sleeve 16 may have connected regions 161 respectively exposed from both ends of the drag chain 15, where the connected regions 161 may be fixedly connected to an outer sidewall of the drag chain 15 in the manner of adhering, twining, or the like.

With further reference to FIG. 13 and FIG. 14, for example, at least in a partial region of the drag chain 15, the screen cable 14 is suspended in the drag chain 15; and the loose region 162 of the anti-friction sleeve 16 is spaced apart from the screen cable 14, and is also spaced apart from the drag chain 15. A more detailed explanation thereof is that, since there is a clearance between an inner surface of the drag chain 15 and an outer surface of the screen cable 14, a risk of friction between the drag chain 15 and the screen cable 14 can be reduced to some extent. In addition, there is also a clearance between the inner surface of the drag chain 15 and the anti-friction sleeve 14, which may further reduce a probability of contact between the drag chain 15 and the anti-friction sleeve 14.

In an ideal situation of this embodiment, since the second end 142 of the screen cable 14 is fixed in the screen assembly and the first end 141 of the screen cable 14 is connected to the screen, through proper selection of positions of the first end 141 of the screen cable 14 and the second end 142 of the screen cable 14 relative to the drag chain 15 and appropriate selection of a type of screen cable 14, the screen cable 14 may be suspended in the drag chain 15 after the screen assembly is assembled, with a substantially equal distance maintained between the screen cable 14 and the inner surface of the drag chain 15. Alternatively, while the above configurations are implemented, a clamping member (for example, a U-shaped member with an opening facing an upper inner surface of the drag chain 15) may also be provided at each of both ends of the drag chain 15 to suspend the screen cable 14. This can also ensure that, after the screen assembly is assembled, a substantially equal distance is maintained between the part of the screen cable 14 located in the drag chain 15 and the inner surface of the drag chain 15.

However, in an actual manufacturing and assembly process, there is a problem of inconsistency between materials of the screen cable 14 and the anti-friction sleeve 16 (that is, physical and chemical properties of various parts of the screen cable 14 and the anti-friction sleeve 16 may not be consistent) and there are factors such as an unavoidable assembly error. As a result, in an actual manufacturing and assembly process, the screen cable 14 can achieve the foregoing effect of being suspended in the drag chain 15 in a partial region of the drag chain 15 only at certain instants.

In continuation of the foregoing, in an actual manufacturing and assembly process, when the design that the connected region 161 of the anti-friction sleeve 16 is bundled with the screen cable 14 is employed, through pre-manufacture of an anti-friction sleeve 16 having a specific shape (for example, a diameter of the connected region 161 is significantly less than a diameter of the loose region 162) or through use of a corresponding bundling method for bundling the screen cable 14 and the anti-friction sleeve 16 (for example, applying opposing forces on both ends of the anti-friction sleeve 16 during bundling the anti-friction sleeve 16 and the screen cable 14 such that a part between the two ends of the anti-friction sleeve 16 bulges), the loose region 162 of the anti-friction sleeve 16 may be spaced apart from the screen cable 14 and may also be spaced apart from the drag chain 15 within a partial region of the drag chain 15.

Similarly, when the design that the connected region 161 of the anti-friction sleeve 16 is fixedly connected to the screen cable 14 is employed, the effect of "the loose region 162 of the anti-friction sleeve 16 may be spaced apart from the screen cable 14, and may also be spaced apart from the drag chain 15" may be achieved by designing a manner of connection between the connected region 161 and the screen cable 14 (for example, enabling the connected region 161 of the anti-friction sleeve 16 to be suspended from the drag chain 15).

For example, in the drag chain 15, a distance b between the anti-friction sleeve 16 (the loose region 162 thereof) and the inner surface of the drag chain 15 is preferably 0.5 mm, and a distance c between the anti-friction sleeve 16 (the loose region 162 thereof) and the outer surface of the screen cable 14 preferably ranges from 0.3 mm to 0.4 mm.

Optionally, in consideration of balancing manufacture costs, the anti-friction sleeve 16 may alternatively be made of hollow strip-shaped foam or sponge. The sponge or foam is provided with connected regions 161 that are separately exposed from the drag chain 15, and the connected regions 161 are fixedly connected to the drag chain 15 or parts of the screen cable 14 that are located outside the drag chain 15. For a specific connection manner, reference may be made to the examples described above.

With further reference to FIG. 15, in this embodiment, the first end 141 of the screen cable 14 is connected to the screen, the drag chain 15 is not exposed to the occupant compartment, and an end of the drag chain 15 that is near the screen is located below a connection point between the screen cable 14 and the screen. After the screen cable 14 extends out of the end of the drag chain 15 that is near the screen, the screen cable 14 further extends upward along the screen-connecting member 10 for a specific distance before being connected to the screen.

Based on this, to facilitate mounting of the screen cable 14, in this embodiment, a coarsely-locating portion 101 is disposed at a middle part of the screen-connecting member 10. The coarsely-locating portion 101 is in a shape of a groove with an opening facing rearward, is arranged in a vertically extending manner, and allows a part of the screen cable 14 to abut against an inner surface of the coarsely-locating portion 101, but does not undertake a function of constraining a routing direction of the screen cable 14. Specifically, the coarsely-locating portion 101 is located on a front side of an end, close to the screen, of the drag chain 15, for allowing the screen cable 14 to be coarsely located. In this way, when the screen assembly is assembled by a worker, positions at which the parts of the screen cable 14 that are exposed from the drag chain 15 are assembled with the screen-connecting member 10 can be quickly determined. Further, when the screen cable 14 is pre-threaded through the drag chain 15 and then assembled with the screen-connecting member 10, since one end of the drag chain 15 is also required to be fixed to the screen-connecting member 10, the coarsely-locating portion 101 further assists a worker in identifying a connection point between the drag chain 15 and the screen-connecting member 10.

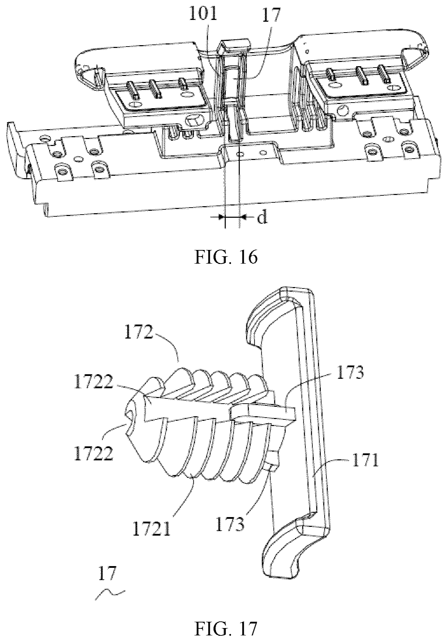

For example, since the coarsely-locating portion 101 is used only for coarsely locating of the screen cable 14, in this embodiment, a routing direction constraining member 17 is further fixed to the groove bottom of the coarsely-locating portion 101, as shown in FIG. 16. The routing direction constraining member 17 can constrain a routing direction of the screen cable 14.

As shown in FIG. 17, in this embodiment, the routing direction constraining member 17 includes a guiding body 171 and a connection portion 172 that are connected to each other as one piece, where the connection portion 172 is used to be directly inserted into the screen-connecting member 10, so as to be fixed to the screen-connecting member 10. The guiding body 171 is provided with a vertical arc-shaped groove, and the arc-shaped groove is used to be mated with a part of the screen cable 14 that is required to extend upward, so as to constrain the part of the screen cable 14 to maintain a vertical routing direction. The connection portion 172 is formed by extending from a middle part of the guiding body 171 toward a direction away from the guiding body 171. The connection portion 172 is substantially in a shape of a Christmas tree, with a crown of the Christmas tree far away from the guiding body 171, and includes a plurality of barbed bodies 1721. The plurality of barbed bodies 1721 are arranged in sequence at intervals from a connection point between the connection portion 172 and the guiding body 171 toward the direction away from the guiding body 171. In this embodiment, among all the barbed bodies 1721, a barbed body 1721 that is farthest away from the guiding body 171 has the smallest size, so that the connection portion 172 can be directly inserted into an object on which the routing direction constraining member 17 is to be mounted.

In addition, the connection portion 172 is further provided with a through groove 1722. The through groove 1722 extends in an arrangement direction of the plurality of barbed bodies 1721. An abutment block 173 is disposed at an end, close to the guiding body 171, of the through groove 1722. In addition, there is a spacing between a barbed body 1721 closest to the guiding body 171 and the guiding body 171, and another abutment block 173 connected to the connection portion 172 as one piece is further provided in the spacing. In this embodiment, the connection portion 172 of each routing direction constraining member 17 is provided with a total of two through grooves 1722 and four abutment blocks 173 arranged at intervals, among which, two abutment blocks 173 are respectively located within the two through grooves 1722, and the other two abutment blocks 173 are located between the barbed body 1721 closest to the guiding body 171 and the guiding body 171.

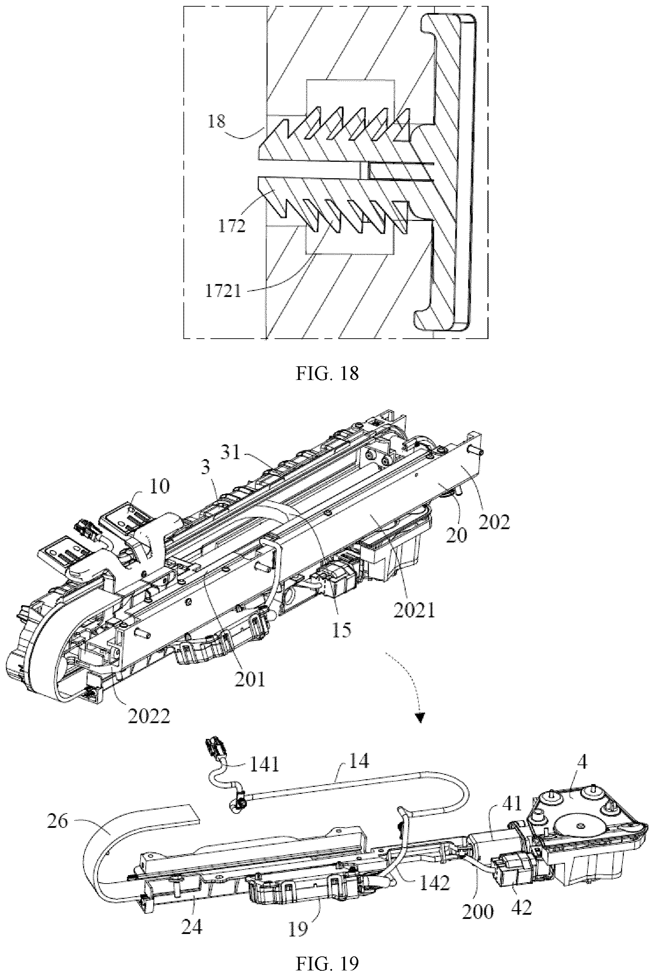

In continuation of the foregoing, in this embodiment, the routing direction constraining member 17 is made of a plastic material having a certain elastic modulus. When the routing direction constraining member 17 is fixed to an object, accordingly, the object is preferably provided with a special-shaped (cross-shaped) hole 18, as shown in FIG. 18. The connection portion 172 of the routing direction constraining member 17 is inserted into the special-shaped hole 18, such that at least some of the barbed bodies 1721 of the routing direction constraining member 17 form a snap-in connection relationship with an inner edge of the special-shaped hole 18. The abutment block 173 (as shown in FIG. 17) abuts against an inner wall of the special-shaped hole 18, thereby achieving a fixed connection between the routing direction constraining member 17 and the object. In addition, because the routing direction constraining member 17 is provided with the barbed body 1721, once the barbed body 1721 is inserted into an object, the barbed body 1721 is difficult to be withdrawn from the object. Therefore, optionally, the routing direction constraining member 17 may be made of a metal material. Certainly, the routing direction constraining member 17 may alternatively be mated with a conventional plain hole. In this embodiment, the screen-connecting member 10 is provided with a mating hole used for snap-in connection with the routing direction constraining member 17, where the mating hole is a conventional plain hole mentioned above.

It should be noted that, in this embodiment, a unilateral distance between the coarsely-locating portion 101 and the routing direction constraining member 17 is at least 20% of a width d of the guiding body 171 (as shown in FIG. 16), to facilitate assembling the routing direction constraining member 17 with the coarsely-locating portion 101. For example, if the width d of the guiding body 171 is 7 mm, a distance between an edge of the coarsely-locating portion 101 that is located on a side surface of the routing direction constraining member 17 and the guiding body 171 should be at least 1.4 mm. A total width of the coarsely-locating portion 101 at a position where the coarsely-locating portion 101 is mated with the routing direction constraining member 17 should be at least 9.8 mm.

In this embodiment, the coarsely-locating portion 101 and the routing direction constraining member 17 are configured as separate structures, so as to reduce difficulty in manufacture of the screen-connecting member 10, thereby indirectly improving the production yield of the screen-connecting member 10. The use of the barbed bodies 1721 and other structures, which may allow the routing direction constraining member 17 to be fixed to the screen-connecting member 10 in an inserting manner, is also based on the consideration that the routing direction constraining member 17 has a relatively small size, and the coarsely-locating portion 101 that is mated with the routing direction constraining member 17 also has a relatively small width. Such a configuration can reduce difficulty of workers in manual assembly. In contrast, if a bolted connection structure is used at this location, it is apparent that an operational difficulty in manufacturing and assembly processes of the routing direction constraining member 17 is increased due to bolt tightening.

With further reference to FIG. 19, as described above, in this embodiment, similar to the first end 141 of the screen cable 14, the second end 142 of the screen cable 14 is also exposed from the drag chain 15. Specifically, the second end 142 of the screen cable 14 is located near the end of the drag chain 15 that is far away from the screen, and is routed in a direction of extending from this end to reach the front side of the first component plate 2021 while passing across an upper opening in the first front sub-member 201, and then further extending downward to the lower side of the second component plate 2022.

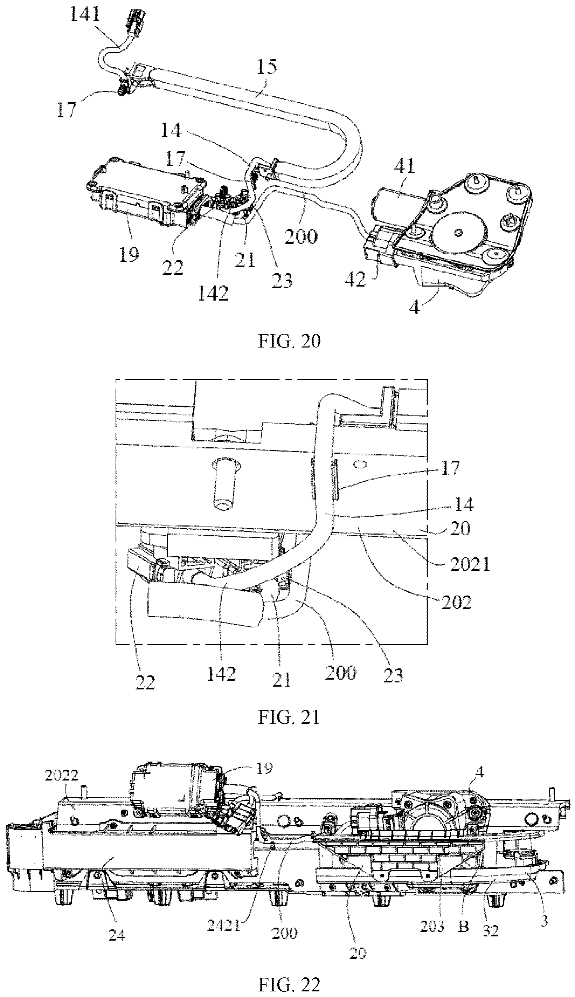

For example, to ensure a direction of a downward-extending part of the screen-connecting member 10, as shown in FIG. 21, in this embodiment, the first component plate 2021 is also provided with a routing direction constraining member 17. Correspondingly, the first component plate 2021 is provided with a mating hole for mounting the routing direction constraining member 17, and the mating hole is in a shape of the special-shaped hole 18.

Referring back to FIG. 19 and FIG. 20, in this embodiment, the screen assembly further includes a controller 19, a control cable 200, and a host-connecting cable 21. The controller 19 is disposed on a right side of the driving portion 4 (located at a left part of the screen assembly). Both the second end 142 and the first end 141 of the screen cable 14 are located outside the drag chain 15. The first end 141 of the screen cable 14 is connected to the screen as described above, while the second end 142 of the screen cable 14 is eventually connected to a first terminal 22 on the lower side of the second component plate 2022. The first terminal 22 is fixedly positioned in the screen assembly and used to form an electrical connection relationship with an entertainment host (not shown) of the vehicle, thereby establishing an electrical connection relationship between the screen and the entertainment host. In addition, in addition to the motor 41 that can drive the winding reel to rotate, the driving portion 4 further includes an interface member 42. A right end of the control cable 200 is connected to the controller 19, and a left end of the control cable 200 is connected to the interface member 42, thereby establishing an electrical connection between the controller 19 and the driving portion 4. One end of the host-connecting cable 21 is connected to the controller 19, while the other end of the host-connecting cable 21 is connected to a second terminal 23. The second terminal 23 is fixedly positioned in the screen assembly and used to form an electrical connection relationship with the entertainment host of the vehicle, thereby enabling the controller 19 to be electrically connected to the entertainment host.

In addition, at least a part of the controller 19, the first terminal 22, the second terminal 23, the control cable 200, and the host-connecting cable 21 are arranged on the lower side of the second component plate 2022. A rear part of the controller 19 is fixedly connected to the second component plate 2022.

In this way, in the wiring scheme of the screen assembly in this embodiment, firstly, most of cables in the screen assembly are routed relatively neatly and concentrated on the lower side of the second component plate 2022, which facilitates the assembly of the screen assembly, and also provides convenience for inspection and maintenance of various components in the screen assembly. Secondly, the wiring scheme of the screen assembly in this embodiment enables a control logic of the screen to include: an exchange of an electrical signal between the screen and the entertainment host; an exchange of an electrical signal between the controller 19 and the driving portion 4; and an exchange of an electrical signal between the controller 19 and the entertainment host. Based on this, a possible movement control scheme of the screen includes the following: An occupant may select, on the screen by touching the screen (for example, using a four-finger gesture), to move the screen in the left or in the right; and the screen transmits a selection of the occupant to the entertainment host by means of transmission of an electrical signal, such that the entertainment host generates a corresponding electrical signal instruction and transmits the electrical signal instruction to the controller 19, and then the controller 19 transmits a command to the driving portion 4, so as to enable a motor controller of the motor 41 in the driving portion 4 to drive the winding reel to rotate, so as to finally drive the screen to move.

The possible movement control scheme of the screen may further include the following: A switch used for controlling the screen to move is mounted on a steering wheel, such that the switch can transmit, to the entertainment host, a signal that requires the screen to move; or a program that can transmit, to the entertainment host, a signal that requires the screen to move is designed on a vehicle control application (APP) that may be installed on any intelligent device.

In addition, with regard to the foregoing arrangement in this embodiment, it should be further noted that, the driving portion 4 is located at the left part of the screen assembly, and the controller 19 is located on the right side of the driving portion 4, instead of integrating the driving portion 4 with the controller 19, because an electronic component in the controller 19 has a relatively large size. If the driving portion 4 is integrated with the controller 19, a size and a weight of the driving portion 4 are greatly increased, and it is difficult to further arrange the driving portion 4 in the frame region B, which is defined by the third front sub-member 203 and the second rear sub-member 32, as shown in FIG. 6 and FIG. 22. Otherwise, modal performance and a gravity center position of the screen assembly are severely affected.

With further reference to FIG. 19 and FIG. 22, for example, the screen assembly in this embodiment further includes a functional casing 24 fixed on the lower side of the second component plate 2022. The functional casing 24 is a multi-functional component that can accommodate the second roller shutter 26, and can also enhance reliability of the wiring structure described above in this embodiment.

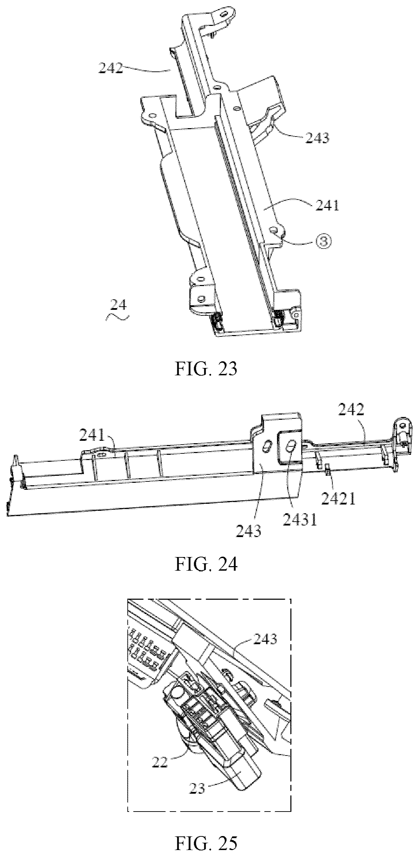

Specifically, in this embodiment, the second roller shutter 26 can slide relative to the front casing 20 and the rear casing 3, and can slide from the upper side of the second component plate 2022 of the front casing 20 to the lower side of the second component plate 2022. In contrast, the functional casing 24 is located on the lower side of the second component plate 2022 and behind the controller 19. The functional casing 24 is located on a movement trajectory of the second roller shutter 26 and is located to the right of the driving portion 4. The functional casing 24 is fixedly connected to the second component plate 2022 (one of connection positions is as shown by a connection point ③ in FIG. 23), and includes, as shown in FIG. 23, a widened portion 241, a narrowed portion 242, and a snap-in position provision portion 243. As shown in FIG. 23 to FIG. 25, a diameter of the widened portion 241 is greater than a diameter of the narrowed portion 242, and the widened portion 241 is approximately in a shape of a right-angled U with an opening facing upward, and is used to accommodate the second roller shutter 26. The narrowed portion 242 is formed by extending leftward from a left part of the widened portion 241, and is provided with a plurality of hooks 2421 arranged at intervals. The hooks 2421 are used to be mated with the control cable 200 that extends from the controller 19 to the driving portion 4, in order to allow the control cable 200 to pass through the hooks 2421 and constrain a routing direction of the control cable 200. The snap-in position provision portion 243 is formed by protruding forward from a front surface of the widened portion 241 and is used to provide a fixing point for each of the second terminal 23 and the first terminal 22, so as to constrain the host-connecting cable 21 and the screen cable 14.

In continuation of the foregoing, a more detailed example arrangement of the snap-in position provision portion 243 is as follows: As shown in FIG. 23 and FIG. 24, the snap-in position provision portion 243 is a right-angled U-shaped member that has an opening facing the widened portion 241 and is connected to the widened portion 241 as one piece. A snap-in hole 2431 that communicates with the interior of the snap-in position provision portion 243 is formed in a lower surface of the snap-in position provision portion 243. As shown in FIG. 25, the first terminal 22 and the second terminal 23 are snapped into the snap-in hole 2431, so that an end of the screen cable 14 and an end of the host-connecting cable 21 are fixedly positioned in the screen assembly.

Referring back to FIG. 2, as described above, the front casing 20 includes the first front sub-member 201, the second front sub-member 202, and the third front sub-member 203, the second front sub-member 202 includes the first component plate 2021 and the second component plate 2022, and the rear casing 3 includes the first rear sub-member 31 and the second rear sub-member 32.

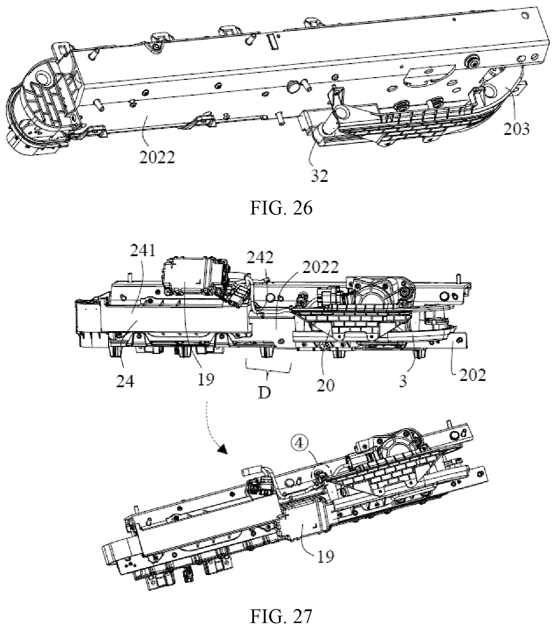

In this embodiment, after the front casing 20 is assembled with the rear casing 3, as shown in FIG. 26 and FIG. 27, the functional casing 24, a part of the third front sub-member 203, a part of the second rear sub-member 32, and the driving portion 4 are all located below the second component plate 2022 of the second front sub-member 202. In view of this, a tangible part that protrudes downward relative to the second component plate 2022 is actually present at a right part on the lower side of the second component plate 2022 due to the presence of the functional casing 24. Another tangible part that protrudes downward relative to the second component plate 2022 is actually present at a left part on the lower side of the second component plate 2022 due to the presence of the part of the third front sub-member 203, the part of the second rear sub-member 32, and the driving portion 4. In this embodiment, the narrowed portion 242 of the functional casing 24 is located between the widened portion 241 of the functional casing 24 and the driving portion 4. Since the diameter of the narrowed portion 242 is less than the diameter of the widened portion 241, a height drop region D is formed between the two tangible parts. The height drop region D is substantially enclosed by the widened portion 241, the narrowed portion 242, the frame region B, and the driving portion 4, and has a certain area and a considerable height difference with respect to its surroundings.

In view of this, an optional solution of this embodiment is to mount the controller 19, located on the front side of the functional casing 24, in the height drop region D, as shown in FIG. 27. In addition, local routing of cables is adaptively changed without changing positions of the first terminal 22 and the second terminal 23 (such adaptive changes are not illustrated in FIG. 27). In addition, avoidance arrangement or shared fixing point design are implemented in a small quantity of regions where interference may occur between the controller 19 and the functional casing 24, the second front sub-member 202, the second rear sub-member 32, or the driving portion 4. The term "avoidance arrangement" refers to slightly modifying a shape of the controller 19, or a shape of the second front sub-member 202, the second rear sub-member 32, or the driving portion 4. The term "shared fixing point design" refers to using regions where interference occurs as connection points arranged in an overlapping manner, allowing a fixing member such as a bolt to sequentially pass through. For a specific example of the overlapping arrangement, reference may be made to the connection point ④ in FIG. 27. In this way, the widened portion 241 of the functional casing 24, the controller 19, and the driving portion 4 are arranged sequentially from right to left below the second component plate 2022. This facilitates the screen assembly to maintain a relatively neat profile (i.e., without excessively protruding parts), and also facilitates a gravity center of the screen assembly to be approximately positioned in the middle of the screen assembly.

For ease of understanding, the foregoing arrangement may also be described as follows:
The functional casing 24 allows a downward-protruding tangible part to be present on a lower surface of the second component plate 2022. The frame region B for mounting the driving portion 4 is formed between the front casing 20 and the rear casing 3, and the frame region B allows a downward-protruding tangible part to be present on the lower surface of the second component plate 2022. A part of the second component plate 2022 is exposed from a space between the functional casing 24, the driving portion 4, and the frame region B. The exposed part of the second component plate 2022, and the surrounding functional casing 24, the driving portion 4, and the frame region B together define the height drop region D, where the controller 19 is disposed in the height drop region D.

In conclusion, by means of allowing the screen assembly to include the drag chain 15 disposed between the front casing 20 and the rear casing 3, allowing the screen cable 14 to be partially routed through the drag chain 15, and disposing the anti-friction sleeve 16 between the drag chain 15 and the screen cable 14, it may be ensured in embodiments of the present application that the screen cable 14 may be not subject to wear and tear that affects its service life during vibration and bumpy road conditions and movement along with the screen-connecting member 10, greatly reducing a breaking risk of the screen cable 14 due to a durability failure. In addition, by means of disposing a part of the screen cable 14 between the front casing 20 and the rear casing 3 along with the drag chain 15, aesthetic appearance of the part of the screen assembly that is exposed to the occupant compartment is further indirectly ensured in embodiments of the present application.

The foregoing descriptions are merely particular implementations of the present application, but the protection scope of the present application is not limited thereto. Any variation or replacement readily figured out by persons skilled in the art within the technical scope disclosed in the present application shall fall within the protection scope of the present application. Therefore, the protection scope of the present application shall be subject to the protection scope of the claims.

## Claims

1. A screen assembly having a movable screen, comprising a screen, a screen-connecting member (10), a front casing (20), and a rear casing (3), wherein the front casing (20) is connected to the rear casing (3); a part of the screen-connecting member (10) is connected to the screen, and a part of the screen-connecting member (10) is located between the front casing (20) and the rear casing (3); and the screen-connecting member (10) is capable of moving relative to the front casing (20) and the rear casing (3), wherein
the screen assembly further comprises a screen cable (14), a drag chain (15), and an anti-friction sleeve (16), wherein the screen cable (14) is partially routed through the drag chain (15) and has two ends that are respectively exposed from different ends of the drag chain (15), and the two ends are a first end (141) and a second end (142); the second end (142) of the screen cable (14) is fixed inside the screen assembly, and the first end (141) is connected to the screen; the drag chain (15) is located between the front casing (20) and the rear casing (3), one end of the drag chain (15) is fixed on the screen-connecting member (10), and the other end of the drag chain (15) is fixed on the front casing (20); and the anti-friction sleeve (16) encloses a part, located in the drag chain (15), of the screen cable (14), the anti-friction sleeve (16) is connected with one of the drag chain (15) and the screen cable (14), and the anti-friction sleeve (16) is not entirely connected with the one of the drag chain (15) and the screen cable (14) in a tightly wrapped manner.

2. The screen assembly having a movable screen according to claim 1, wherein a part of the anti-friction sleeve (16) is connected with the one of the drag chain (15) and the screen cable (14); the anti-friction sleeve (16) is provided with a connected region (161) and a loose region (162); the connected region (161) of the anti-friction sleeve (16) is in contact with and connected to the screen cable (14); and the loose region (162) of the anti-friction sleeve (16) is at least partially located in the drag chain (15).

3. The screen assembly having a movable screen according to claim 2, wherein at least in a partial region of the drag chain (15), the screen cable (14) is suspended in the drag chain (15); and the loose region (162) of the anti-friction sleeve (16) is spaced apart from the screen cable (14), and is also spaced apart from the drag chain (15).

4. The screen assembly having a movable screen according to claim 2 or 3, wherein the anti-friction sleeve (16) is provided in either of the following two manners:
the anti-friction sleeve (16) is a tubular woven net, the woven net has two connected regions (161) that are respectively exposed from two ends of the drag chain (15), and the two connected regions (161) abut on and are connected, in a bundling manner, to a part of the screen cable (14) that is located outside the drag chain (15); or
the anti-friction sleeve (16) is a tubular woven net, the woven net has two connected regions (161) that are respectively exposed from two ends of the drag chain (15), and the two connected regions (161) are fixedly connected to the drag chain (15).

5. The screen assembly having a movable screen according to any one of claims 1 to 4, further comprising a controller (19), a driving portion (4), a control cable (200), and a host-connecting cable (21), wherein a second component plate (2022) located on lower sides of the screen-connecting member (10) and the drag chain (15) is disposed in the screen assembly; the driving portion (4) is fixed to a lower side on one end of the second component plate (2022); the controller (19) is disposed on a side of the driving portion (4); the screen cable (14) is connected to the screen at the first end (141), and is connected, at the second end (142), to a first terminal (22) having a fixed position; and the first terminal (22) is used to form an electrical connection relationship with an entertainment host, such that the screen is electrically connected to the entertainment host; and
the driving portion (4) comprises a motor (41) capable of driving the screen-connecting member (10) to move, and an interface member (42) electrically connected to a motor control unit; one end of the control cable (200) is connected to the controller (19), and the other end of the control cable (200) is connected to the interface member (42), such that the controller (19) is electrically connected to the driving portion (4); one end of the host-connecting cable (21) is connected to the controller (19), and the other end of the host-connecting cable (21) is connected to a second terminal (23) having a fixed position; the second terminal (23) is used to form an electrical connection relationship with the entertainment host, such that the controller (19) is electrically connected to the entertainment host; and at least a part of the controller (19), the first terminal (22), the second terminal (23), the control cable (200), and the host-connecting cable (21) are arranged on a lower side of the second component plate (2022).

6. The screen assembly having a movable screen according to claim 5, wherein the front casing (20) comprises a first component plate (2021) vertically arranged and the second component plate (2022) horizontally arranged; the screen assembly further comprises a decorative roller shutter and a functional casing (24); the decorative roller shutter comprises a first roller shutter (25) and a second roller shutter (26) that are respectively connected to a left part and a right part of the screen-connecting member (10); and each of the first roller shutter (25) and the second roller shutter (26) mates with the front casing (20) and the rear casing (3), and is capable of sliding from upper sides of the first component plate (2021) and the second component plate (2022) to lower sides of the first component plate (2021) and the second component plate (2022) relative to the front casing (20) and the rear casing (3); and
the screen assembly comprises the functional casing (24) located on the lower side of the second component plate (2022), and the functional casing (24) is located on a movement trajectory of the second roller shutter (26), and is located on a side, close to the controller (19), of the driving portion (4), and near the controller (19); and the functional casing (24) is capable of accommodating the second roller shutter (26) and causing the control cable (200) extending from the controller (19) toward the interface member (12) to be mated with the functional casing (24), to constrain a routing direction of the control cable (200).

7. The screen assembly having a movable screen according to claim 6, wherein the functional casing (24) is fixedly connected to the second component plate (2022), and comprises a widened portion (241), a narrowed portion (242), and a snap-in position provision portion (243) that are connected to each other as one piece, wherein a diameter of the widened portion (241) is greater than a diameter of the narrowed portion (242); the widened portion (241) is used to accommodate the second roller shutter (26); the snap-in position provision portion (243) is formed by protruding from a side surface of the widened portion (241) toward a direction away from the widened portion (241), and is used to provide a fixing point for each of the second terminal (23) and the first terminal (22), so as to constrain the host-connecting cable (21) and the screen cable (14); and the narrowed portion (242) is formed by extending from an end, close to the driving portion (4), of the widened portion (241) toward the driving portion (4), and is provided with a hook (2421), wherein the hook (2421) is used to allow the control cable (200), which extends from the controller (19) to the driving portion (4), to pass through the hook (2421), so as to constrain a routing direction of the control cable (200).

8. The screen assembly having a movable screen according to claim 7, wherein a routing direction of the screen cable (14) from the first terminal (22) to the screen is configured as follows: starting from the first terminal (22), the screen cable (14) extends upward from the lower side of the second component plate (2022), extends past a front side of the first component plate (2021) into a space between the rear casing (3) and the front casing (20) to enter the drag chain (15), extends from the front casing (20) toward the rear casing (3), and further extends upward along the screen-connecting member (10) from a side of the rear casing (3) facing the front casing (20) into a space between the screen-connecting member (10) and the screen.

9. The screen assembly having a movable screen according to claim 8, further comprising two routing direction constraining members (17), wherein one of the two routing direction constraining members (17) is disposed on a front surface of the first component plate (2021), and the other of the two routing direction constraining members (17) is disposed on the screen-connecting member (10); the routing direction constraining members (17) are used to constrain the routing direction of the screen cable (14); each of the routing direction constraining members (17) comprises a guiding body (171) and a connection portion (172) that are connected to each other as one piece; the connection portion (172) is used to be directly inserted into the screen-connecting member (42) to fix a corresponding routing direction constraining member (17) onto the screen-connecting member (42); and the guiding body (171) is provided with an arc-shaped groove, and the arc-shaped groove is used to be mated with a part of the screen cable (14), so as to constrain a routing direction of the part of the screen cable (14).

10. The screen assembly having a movable screen according to claim 9, wherein the connection portion (172) is formed by extending from the guiding body (171) toward a direction away from the guiding body (171) and comprises a plurality of barbed bodies (1721); the plurality of barbed bodies (1721) are arranged in sequence at intervals from a connection point between the connection portion (172) and the guiding body (171) toward the direction away from the guiding body (171), such that the connection portion (172) is in a shape of a Christmas tree, with a crown of the Christmas tree far away from the guiding body (171); and the connection portion (172) is further provided with an abutment block (173); and
each of the first component plate (2021) and the screen-connecting member (10) is provided with a mating hole that is used for snap-in connection with a corresponding routing direction constraining member (17); the abutment block (173) is used to abut against an inner wall of the mating hole; and the connection portion (172) is used to be snapped into the mating hole to fix a corresponding routing direction constraining member (17) onto the first component plate (2021) or the screen-connecting member (10).

11. The screen assembly having a movable screen according to claim 10, wherein a coarsely-locating portion (101) is provided on the screen-connecting member (10); the coarsely-locating portion (101) is located near an end, close to the screen, of the drag chain (15), for allowing a part of the screen cable (14) to be coarsely located; a mating hole for insertion of the routing direction constraining member (17) is formed at a groove bottom of the coarsely-locating portion (101); the coarsely-locating portion (101) is configured to accommodate the routing direction constraining member (17); and a unilateral distance between the coarsely-locating portion (101) and the guiding body (171) is at least 20% of a width of the guiding body (171).

12. The screen assembly having a movable screen according to any one of claims 5 to 11, wherein the functional casing (24) allows a downward-protruding tangible part to be present on a lower surface of the second component plate (2022); a frame region for mounting the driving portion (4) is formed between the front casing (20) and the rear casing (3), and the frame region allows a downward-protruding tangible part to be present on the lower surface of the second component plate (2022); a part of the second component plate (2022) is exposed from a space between the functional casing (24), the driving portion (4), and the frame region; and the exposed part of the second component plate (2022), and the surrounding functional casing (24), the driving portion (4), and the frame region together define a height drop region, wherein the controller (19) is disposed in the height drop region.

13. A vehicle, comprising the screen assembly having a movable screen according to any one of claims 1 to 12, wherein the screen assembly is fixed onto a dashboard assembly, and a recessed region used to accommodate a part of the screen assembly is disposed inside the dashboard assembly.
